# EUROPEAN PATENT SPECIFICATION

(11) **EP 0 315 803 B1**
(45) Date of publication and mention of the grant of the patent: **05.01.1994**
(21) Application number: 88117363.7
(22) Date of filing: 19.10.1988
(51) Int. Cl.: H01L 27/10, H01L 27/12, H01L 21/82

(54) **A DRAM cell formed on an insulating layer having a buried semiconductor pillar structure and a manufacturing method thereof**
DRAM-Zelle, die auf einer Isolierschicht gebildet ist und die eine begrabene Halbleiter-Säulenstruktur aufweist und ein Herstellungsverfahren dafür
Cellule DRAM, formée sur un substrat isolant, comportant une structure enterrée de pilier et son procédé de fabrication

(30) Priority: 10.11.1987 JP 283839/87
(43) Date of publication of application: 17.05.1989
(73) Proprietor: FUJITSU LIMITED, Kawasaki-shi, Kanagawa 211 (JP)
(72) Inventor: Gotou, Hiroshi, Niiza-shi Saitama 352 (JP)
(74) Representative: Seeger, Wolfgang, Dipl.-Phys.

(56) References cited:
- EP-A- 0 198 590
- IBM TECHNICAL DISCLOSURE BULLETIN, vol. 24, no. 8, January 1982, pages 4239-4243, IBM Corp., New York, US; C.G. JAMBOTKAR: "Methods to fabricate very dense arrays of dynamic RAM cells"
- PATENT ABSTRACTS OF JAPAN, vol. 10, no. 244 (E-430)[2300], 22nd August 1986; & JP-A-61 73 366
- PATENT ABSTRACTS OF JAPAN, vol. 12, no. 291 (E-644)[3138], 9th August 1988; & JP-A-63 66 963

## Description

### 1. Field of the Invention

This invention relates to a dynamic random access memory (hereinafter, abbreviated as DRAM) cell structure of one-transistor and a capacitor type and a manufacturing method thereof. More specifically, this invention relates to a DRAM cell structure suitable for obtaining a memory capacity equal to or more than 4 Mbits. The present invention is intended to reduce a cell area, simplify fabrication processes by minimizing a number of necessary mask steps and increase a device reliability by a better isolation between adjacent cells.

### 2. Description of the Related Art

With an increase of a memory capacity, a cell structure of the DRAM device shows a trend of adopting a three-dimensional type rather than a planar type. As one of examples, wherein one-transistor and a capacitor are formed vertically in a deep trench, is disclosed at IEDM 85 (1985 IEEE International Electron Device Meeting): "A trench transistor cross-point DRAM cell" by W.F. Richardson et al. IEDM Tech. Dig. 1985, pp. 714-717.

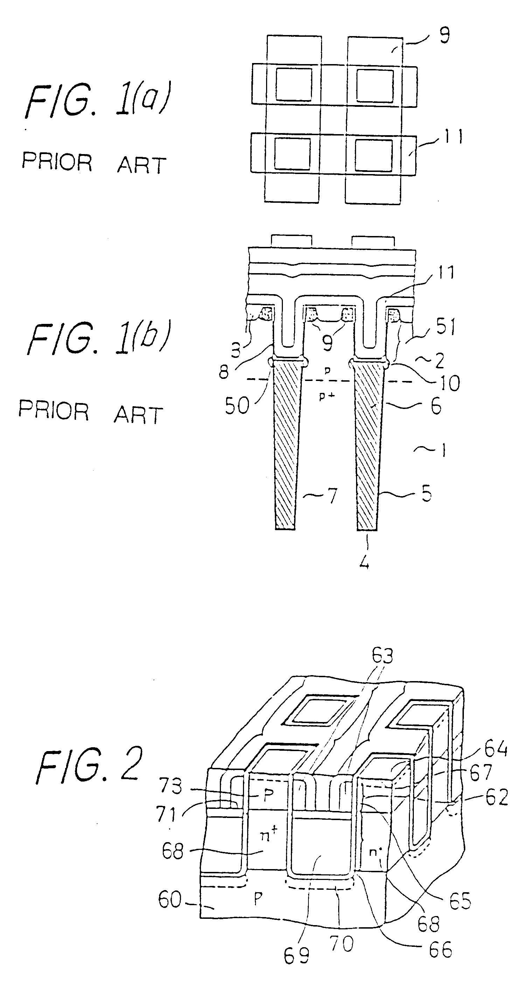

Fig. 1(a) shows a top view of the cell layout and Fig. 1(b), a cross section of the DRAM cell disclosed above. A p-type epitaxial layer 2 is grown on a p⁺-type substrate 1. A recessed oxide isolation 3 and n⁺-type diffusion region 9 are formed surrounding a trench 4, and diffusion region 9 functions as a drain of the vertically formed NMOS transistor 51 and the drain is mutually connected with adjacent drains arranged in the Y-direction of rectangular coordinates, forming a bit line. After forming the trench 4, a capacitor dielectric film 5 is formed on an inner wall of the trench and the trench is filled with phosphorous doped polysilicon. The doped polysilicon is etched back leaving a storage electrode 6.

A trench wall around the top of the storage electrode 6 is partially etched and removed, and a buried lateral contact 10 of polysilicon is deposited therein. The buried lateral contact 10 is later subjected to a thermal diffusion of phosphorous impurities from the storage electrode 6 and serves as a source of the vertical NMOS transistor 51. Thereafter, a gate oxide film 8 is formed by thermal oxidation on an inner cylindrical wall of the trench and a thicker oxide layer 50 is formed on the top of the storage electrode 6 by the thermal oxidizing process. And finally, a word line 11, which works as a gate of the NMOS transistor 51, is formed by depositing and patterning the phosphorous doped polysilicon or aluminum alloy.

In Fig. 1(b), a capacitor is composed of the storage electrode 6 and the surrounding substrate portion thereof, the dielectric film 5 being sandwiched therebetween. The above substrate portion surrounding the trench is used as the common capacitor electrode for all cells and is called a cell plate 7.

When a bit information is input through the bit line 9 to a specific cell which is addressed by the word line 11, the NMOS transistor 51 becomes conductive and electric charges are stored in the capacitor. The structure of Figs. 1(a) and 1(b) utilizes the capacitor which is formed deep in the trench below the transistor, therefore, the effective capacitance of the memory cell can be easily increased with a depth of the trench within a limited cell area, resulting in achieving a high integration density of DRAMS.

However, the above structure has problems such that the recessed oxide isolation 3 requires a specified distance between neighboring diffusion regions 9 and it limits an achievable minimum gap distance between cells, and further, if a short gap between cells is selected, it brings about a punch-through phenomenon between diffusion regions 9 (drain) resulting in a memory failure or error of information.

An improved structure of DRAM is disclosed by K. Minegishi, T. Morie, and et al in Japanese Unexamined Patent Publication SHO-63-66963 dated March 25, 1988. Fig. 2 shows a schematic perspective view of the structure of the above DRAM, wherein two sectional views are illustrated taken along the lines X-axis and Y-axis. The vertical NMOS transistor 62 is formed in an isled pillar region 64 on a p-type substrate 60, the pillar region being surrounded by insulating layers 65 and 66. The NMOS transistor 62 is comprises an n⁺-type drain 67, and an n⁺-type source occupying a top portion of an n⁺-type epitaxial layer 68. A gate electrode 63 is formed outside the isled pillar region 64 insulated by a gate insulating layer 65, and serves as a word line. In the figure, a bit line, formed on a top of the isled region 64 and connecting plural drains 67 in the X-direction, are omitted. A capacitor is formed, composed of the n⁺-type epitaxial layer 68 (called a storage electrode), a doped polysilicon 69 (called a cell plate), and the insulating layer 66 sandwiched therebetween.

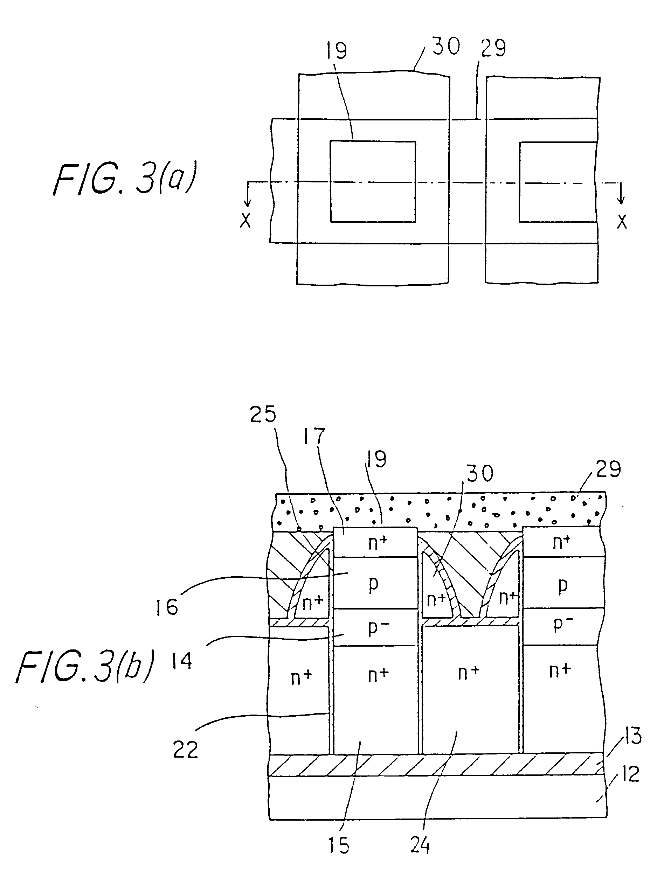

As seen in Fig. 2, a p⁺-type isolation region 70 is required which is formed by a boron ion implantation in a p-type substrate 1, and it should be formed at the lower portion of the trench before it is buried with the doped polysilicon 69. The isolation region 70 of a high impurity concentration is required to eliminate a leakage of electric charges between adjacent storage electrodes 68, because the cell plate (doped polysilicon 69) induces easily an inversion layer on an opposite bottom surface of the insulating layer 66.

The above DRAM structure has a problem that a level of the lower surface 71 of the gate electrode 63 should be formed substantially equal to an interface level between the n⁺ epitaxial layer 68 and p-type epitaxial layer 73 where the channel region and drain 67 of NMOS transistor 62 are formed.

Due to the above two factors, i.e., formation of the isolation region 70 and level matching, the fabrication of this type of DRAM is not so easy and it is difficult to obtain a good reliability.

EP-A-0 198 590 discloses a memory structure where the control device and one capacitor electrode are formed as regions on the side walls of a semiconductor pillar which is formed directly on the substrate. The second capacitor electrode and the gate electrodes are formed in an adjacent trench, the gate electrodes of neighbouring cells in our direction being separated.

JP-A-61 73 366 discloses a memory structure where the cells are separated by isolation regions, each cell consisting of a pillar and an adjacent trench. The pillar is formed directly on the substrate and incorporates the control device and one capacitor electrode. The second capacitor electrode and the gate electrode are formed in the adjacent trench.

### SUMMARY OF THE INVENTION

It is a general object of the invention, therefore to provide a cell structure suitable for obtaining a 4 Mbit or 16 Mbit DRAM device and a manufacturing method thereof.

It is a more specific object of the invention to provide a DRAM cell structure having the above memory capacity within a minimum chip area such as the substantially equal area as that for a conventional 1 Mbit or 256 Kbit DRAM device.

It is another object of the invention to provide a DRAM cell structure minimizing an interference from adjacent cells.

It is still another object of the invention to provide a manufacturing method of a DRAM cell structure fabricated with a minimum number of mask steps resulting in simplifying and shortening the manufacturing processes.

Foregoing and related objects are accomplished by the invention of a DRAM cell structure, in which one-transistor and a capacitor are formed three-dimensionally in a silicon-on-insulator (SOI) structure. The source, drain and channel regions of a MOS FET and a first electrode (a storage electrode) of a capacitor are vertically formed in a pillar structure on the insulating layer of the SOI, covered with a surrounding insulating film. The pillar structure is surrounded and buried with a second electrode of the capacitor (called a cell plate which is a common electrode to all memory cells), and a gate electrode of the MOS FET is formed above the cell plate surrounding the channel region of the MOS FET.

All active elements in the semiconductor pillar such as the source and drain regions, the channel region and the storage electrode are completely isolated from neighboring cells. The punch-through phenomenon between diffusion regions 9 explained for the structure of Fig. 1(b) can be avoided, or the isolation region 70 explained in Fig. 2 is not necessary.

Other objects and advantages of the present invention will become apparent from the detailed description to follow taken in conjunction with the appended claims.

### BRIEF DESCRIPTION OF THE DRAWINGS

Figs. 1(a) and 1(b) show a top view and a cross section respectively of a DRAM cell structure of the prior art, in which a cell capacitor is formed deep in a trench and under a vertical transistor,
Fig. 2 shows a schematic perspective view of another DRAM cell structure
Figs. 3(a) and 3(b) show a top view and a cross sectional view respectively of the DRAM cell structure according to the present invention,
Figs. 4(a), 4(b) through 14(a), 14(b), show successive steps in the fabrication of the DRAM cell shown in Figs. 3(a) and 3(b) of the present invention,
Fig. 15(b) shows a cross section of the first modification of the embodiment according to the present invention, and Fig. 15(a) shows a cross section of the initial substrate used therefor,
Fig. 16(b) shows a cross section of the second modification of the embodiment according to the present invention, and Fig. 16(a) shows a cross section of the initial substrate used therefor, and
Fig. 17 shows a cross section of the third modification of the embodiment according to the present invention.

### DETAILED DESCRIPTION OF THE PREFERRED EMBODIMENTS

Figs. 3(a) and 3(b) show respectively a top view and a cross section taken along line X-X of a DRAM cell structure in which an embodiment of the present invention is applied.

On a silicon substrate 12, an insulating layer 13 of silicon dioxide is formed. A semiconductor pillar 19 is formed on the insulating layer 13 and the pillar 19 comprises a first n-type high impurity concentration layer 15 (hereinafter, abbreviated as a first n⁺ layer), a p-type low impurity concentration layer 14 (hereinafter, abbreviated as a p⁻ layer), p-type channel layer 16, and a second n⁺ layer 17 in an order from the bottom. The first n⁺ layer 15 serves as a storage electrode and the second n⁺ layer 17, as a drain region of a MOS FET.

A lower portion of the sides of the pillar 19 is covered with a dielectric film 22, and the corresponding portion of the gap between the pillars is buried with an n⁺ polysilicon 24, which functions as a cell plate 24 and forms a capacitor incorporated with the storage electrode 15 and the dielectric film 22.

In an upper portion of the gap between pillars, a gate electrode 30 of doped polysilicon is formed, surrounding the pillar 19 at a corresponding height of the p-type channel layer 16 in the pillar, and the gate electrode 30 is insulated from the pillar by a gate insulating film 25. The plural gate electrodes 30 which are aligned in the Y-direction are mutually connected with each other and are forming a word line 30, however, each word line 30 is separated and insulated from the neighboring word lines.

On a top of the cell structure, a bit line 29 of aluminum or aluminum alloy is formed connecting the second n⁺ layers 17 in a X-direction.

In the embodiment described above, the NMOS FET is formed vertically in an upper portion of the cell and the capacitor is buried below the NMOS FET, the cell structure being formed three-dimensionally. A surface area each memory cell occupies may be remarkably reduced. Each memory cell is formed isolated from the adjacent memory cells, each active element being covered with either an insulating film or a thick insulating layer except the cell plate 24 which is utilized as a common electrode for all memory cells. Therefore, the punch-through failure observed in the prior art is avoided and the reliability in storing information is greatly increased.

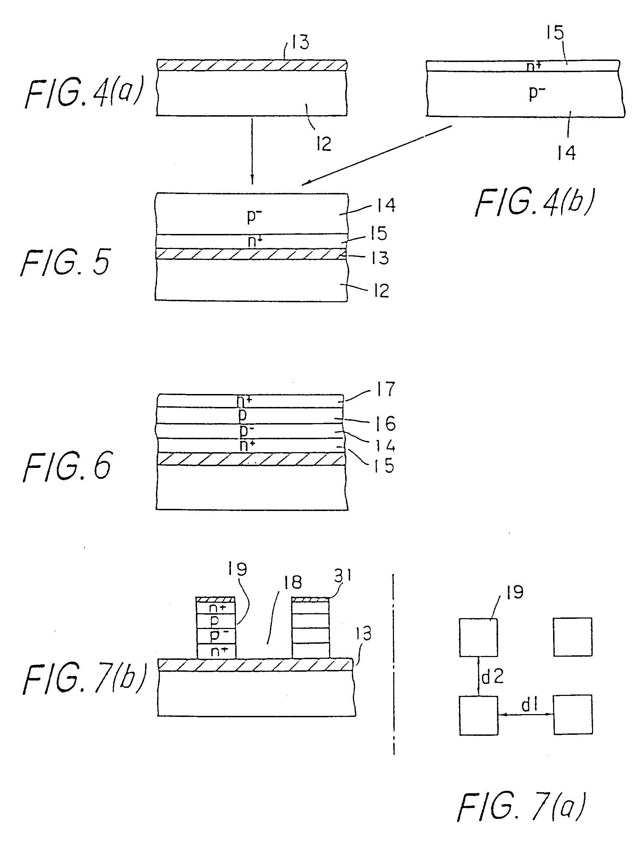

Further details of the structure of the above embodiment and a manufacturing method thereof are explained using Figs. 4 through 14.

As shown in Figs. 4(a) and 4(b), two silicon substrates [p-type Si(100)] are used in a first step. A first silicon substrate 12 is subjected to a thermal oxidation and silicon dioxide (SiO₂) layer 13 with a thickness of 0.5 micron is formed on the substrate. On a second silicon substrate 14, an n⁺-type epitaxial layer 15 having an impurity concentration of 1.0 x 10²⁰ cm⁻³ is grown thereon having a thickness of about 5 microns. Two substrates are brought together, silicon substrate 14 being turned over and the n⁺-type epitaxial layer 15 contacting with the SiO₂ layer 13 as shown in Fig. 5. A bonding technique is applied to two silicon substrates between which only a SiO₂ layer is present.

Though the bonding technique has been a known technology in the prior art, there have been many accompanying problems therewith in a practical application. Recently, the bonding technique has been reconsidered as one of silicon-on-insulator (SOI) technologies, and the following document discloses one of bonding techniques, the disclosure of which is also incorporated herein by reference.

"Silicon-on-insulator (SOI) by bonding and etch-back" by J.B. Lasky et al. IEDM Tech. Dig. 1985, pp. 684-687.

In the present embodiment, the following SOI technique is applied. In order to achieve a firm bonding between two silicon substrates, sandwiching a SiO₂ layer therebetween, an electrostatic pressure bonding method is applied. An electric pulse having a voltage such as 300 Volts (selected in a range between 100 to 500 Volts) is applied between two substrates, heating the substrate temperature up to 800°C in an inert gas (nitrogen) atmosphere. The time required for the application of electric pulse is about a few minutes, during which the substrates are subjected to a strong electrostatic attracting force. Thereafter, the substrates are annealed at a temperature of 1100°C for about 30 minutes in the inert gas atmosphere. After the bonding process, the surface of the substrate 14 is subjected to polishing and lapping processes until the total height of the n⁺-type epitaxial layer 15 and the remaining substrate 14 is brought to about 8 microns.

The substrate (hereinafter, bonded two substrates are briefly called the substrate) is subjected to boron and subsequently arsenic ion implantation processes, and thereafter annealed at about 1000°C. These processes result in forming four layers on the SiO₂ layer 13 as shown in Fig. 6. Four layers are composed of (1) a second n⁺ layer, hereinafter, called a drain diffusion layer 17 having an impurity concentration of 1.0 x 10²⁰ cm⁻³ and a thickness of 0.4 micrometer, (2) a p-type channel layer 16 having an impurity concentration of 1.0 x 10¹⁶ cm⁻³ and a thickness of 1.6 micrometer, (3) a p-type original substrate layer 14, hereinafter briefly called the p⁻ layer 14, having an impurity concentration of 1.0 x 10¹⁵ cm⁻³ and a thickness of 1.0 micrometer, and (4) the original epitaxial layer 15 having an n-type impurity concentration of 1.0 x 10²⁰ cm⁻³ and a thickness of 5.0 micrometer.

Next, a CVD (Chemical Vapor Deposition) SiO₂ layer and a resist layer (these are not shown in the figure) are formed on the substrate surface, and the resist layer is photolithographically patterned. The exposed CVD SiO₂ layer is etched away leaving a mask of CVD SiO₂ layer 31 in Fig. 7(b) for forming a trench. The substrate is subjected to an anisotropic etching process such as RIE (Reactive Ion Etching). As shown in Fig. 7(b), deep trenches 18 are formed leaving a plurality of semiconductor pillars 19 on the SiO₂ layer 13, the pillars being arranged on positions forming a matrix array, and each pillar having a cross section of 0.7 micrometer by 0.7 micrometer. The gap d1 between pillars in the X-direction is greater than that (d2) in the Y-direction as shown in a top view of Fig. 7(a). In the embodiment, d1 is selected to be 1.1 micrometer and d2, 0.7 micrometer.

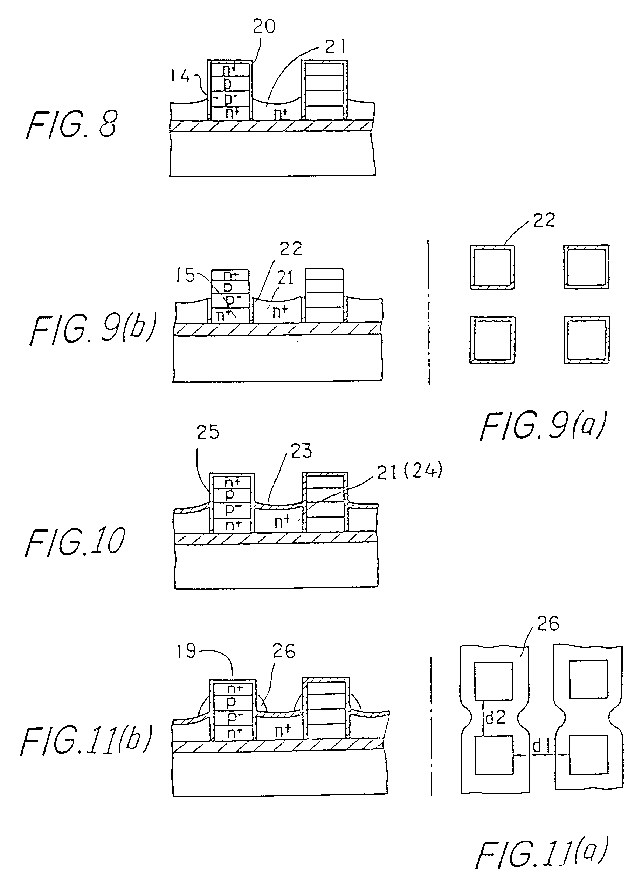

After removing the mask layer 31 of CVD SiO₂, the substrate is thermally oxidized forming a SiO₂ film 20 on the pillar surface. The SiO₂ film 20 has a thickness of 120 angstroms and serves as a dielectric film 22 between capacitor electrodes. As shown in Fig. 8, the trenches are buried by doped polysilicon CVD, a monosilane (SiH₄) or dichlorosilane (SiH₂Cl₂) gas and a phosphine (PH₃) gas being used as a source and additive gas respectively. The phosphorus impurity concentration of this process is about 1.0 x 10²¹ cm⁻³. Other method of impurity doping such as an ion implantation can be utilized. The excess polysilicon is etched back, controlling a surface level of the remaining doped polysilicon layer 21 to correspond to within the height level of p⁻ layer 14. Thereafter, the exposed SiO₂ film 20 is removed and the structure shown in Figs. 9(a) and 9(b) is obtained. The doped polysilicon layer 21 and the n⁺ layer 15 are called respectively a cell plate 24 and storage electrode 15 of the capacitor.

Next as shown in Fig. 10, the substrate is again thermally oxidized, and a gate SiO₂ film 25 is newly formed having a thickness of 200 angstroms. In this process, a thick SiO₂ layer 23 of 400 angstrom thickness is formed on the doped polysilicon layer 21.

Next, in the similar way as depositing doped polysilicon layer 21, a phosphorus doped polysilicon layer (an impurity concentration of 1.0 x 10²¹ cm⁻³) is grown on the substrate by a CVD method, and is etched back leaving a doped polysilicon layer 26 on upper sides of the pillar 19 by a RIE method. The remaining polysilicon layer 26 has a thickness which becomes progressively thicker from a top position of the pillar. As explained previously, the gap between the pillars is set up differently, d1 being larger than d2 in Fig. 11(a). Therefore, the grown polysilicon layer is separated and isolated completely in the X-direction after the etch back process, however, the grown polysilicon layer remains continuous between the gaps in the Y-direction as shown in a top view of Fig. 11(a). The doped polysilicon layer 26 functions as a gate electrode of the vertical MOS FET, and a plurality of gate electrodes in the Y-direction is automatically connected and works as a word line 30 of the DRAM device.

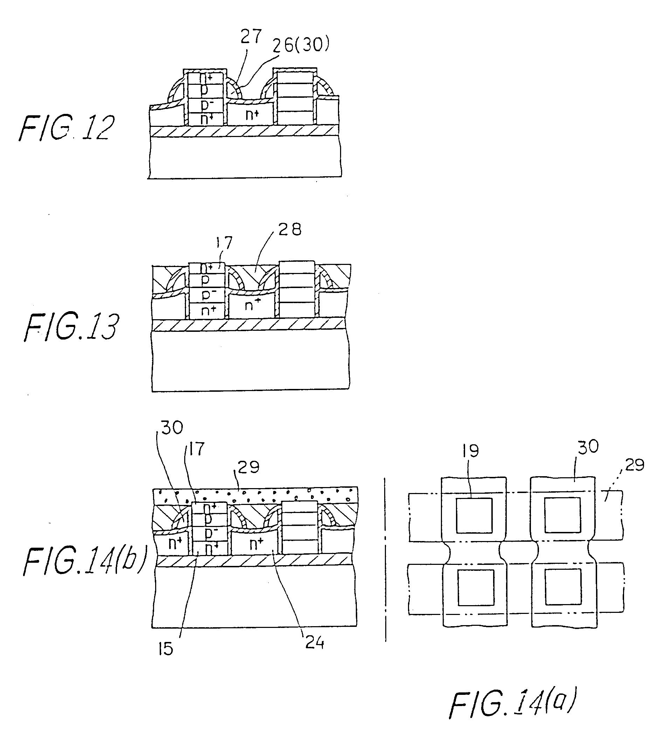

As shown in Fig. 12, the surface of the doped polysilicon layer 26 is thermally oxidized forming a SiO₂ layer 27. Thereafter, the entire surface of the substrate is deposited with phospho-silicate-glass (PSG) by a CVD method, and the deposited PSG layer 28 is etched back until the surface of the drain diffusion layer 17 of the semiconductor pillar is exposed and shows a flat surface with the leveled PSG layer 28 as seen in Fig. 13.

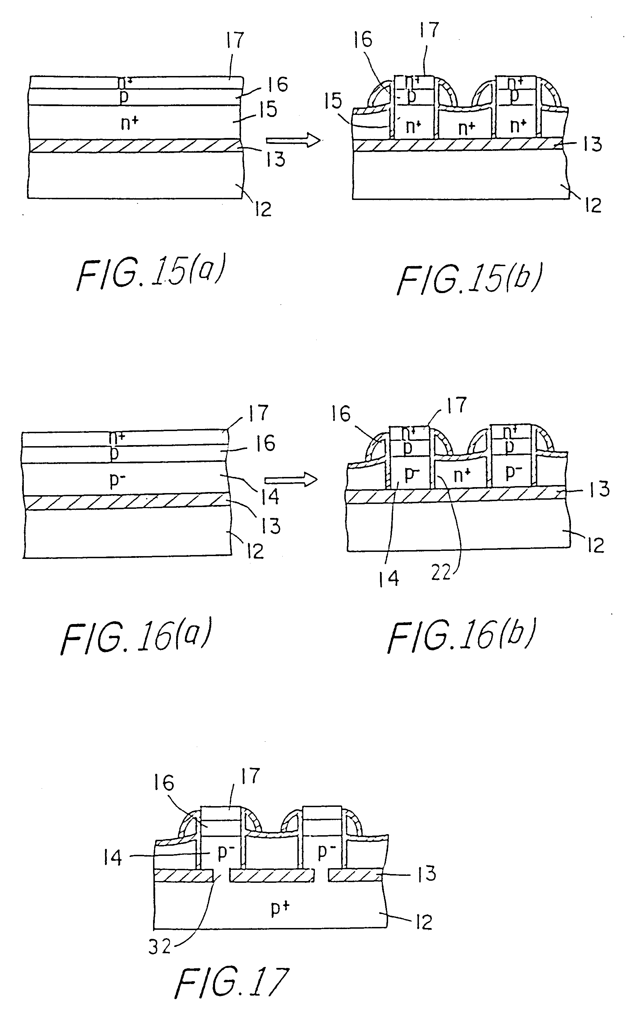

An aluminum or aluminum alloy layer is deposited on the entire surface of the substrate, and is patterned photolithographically, forming a bit line 29 which is connecting plural drain diffusion layers 17 in the X-direction. The final cell structure shown in Figs. 14(a) and 14(b) can be obtained. The figures are similar as those shown in Figs. 3(a) and 3(b).

In the manufacturing method of the above embodiment, only two mask processes are required. The first mask process is applied in the step of forming the semiconductor pillars 19 as explained using Figs. 7(a) and 7(b). The second mask process is applied in the step of forming a bit line. Other elements of the cell structure are automatically formed self-aligned. Therefore, the manufacturing method of the present invention is very effective to shorten the fabrication term and to get a high yield. And further, a number of chances to prepare a mask alignment tolerance is reduced, which is necessary for each mask step after the first mask step, with a result of making a very fine cell structure possible.

In the above embodiment, the p-type channel layer 16 and the p⁻ layer 14 are formed vertically in the semiconductor pillar 19. This is because, even when the upper surface level of the cell plate 24 changes between the upper and lower surface levels of the p⁻ layer 14, the channel length of the MOS FET is predominantly controlled by the thickness of the p-type channel layer 16 only. The fluctuation of the channel length is reduced to a minimum.

As a first modification of the above embodiment, the cell structure shown in Fig. 15(b) may be used, wherein the p⁻ layer 14 is eliminated from the structure of the previous embodiment. This structure is fabricated utilizing the substrate shown in Fig. 15(a), the substrate being formed by controlling the thickness of the n⁺ epitaxial layer 15 and the depth of the boron ion implantation after polishing and lapping processes of p⁻ layer 14 explained in Figs. 4(b), 5, and 6. The structure has a merit such that a comparatively larger capacitance can be obtained than that of the previous embodiment with the same surface area of each cell. However, this type is easily influenced by a fluctuation of the channel length.

As a second modification, the cell structure shown in Fig. 16(b) may be used which is fabricated utilizing the substrate shown in Fig. 16(a), wherein the process of forming the n⁺ epitaxial layer 15 is omitted from the previous embodiment. The p⁻ layer 14 has a function as a storage electrode, and an inversion layer is formed on an inside surface of the dielectric film 22. The channel length can be determined easily at a fixed value, and the fluctuation of a threshold voltage Vth of the MOS FET is comparatively small.

As a third modification is shown Fig. 17, which is a modification from the structure shown in Fig. 16(b). The p⁻ layer 14 or a storage electrode is further connected to the substrate 12 through a hole 32 formed in the insulating layer 13. This type of cell structure is used in such a way that the substrate 12 is grounded during operation in order to avoid a potential fluctuation of the p⁻ layer 14, therefore, this type has a stronger resistant characteristic against noises. As a result, the DRAM device of this type has a higher reliability than that of a DRAM device which has the same cell capacitance.

## Claims

1. A semiconductor memory device having a memory cell comprising a transistor stacked on a capacitor thereof, a word line and a bit line, said semiconductor memory device comprising:
(a) a first insulating layer formed on a semiconductor substrate;
(b) a semiconductor pillar structure formed on said first insulating layer, said pillars being arranged on positions forming a matrix array and being separated by trenches extending to said first insulating layer, said pillar structure comprising a first semiconductor layer of a first conductivity type formed on said first insulating layer, a second semiconductor layer of a second conductivity type opposite to the first conductivity type formed on said first semiconductor layer, and a third semiconductor layer of the first conductivity type formed on said second semiconductor layer, and said transistor being formed in an upper portion of the pillar structure and said capacitor being formed in a lower portion of the pillar structure;
(c) a second insulating layer formed over a side surface of said pillar structure having a first and second regions, the first region being used as an insulating layer of said capacitor and the second region being used as a gate insulating layer of said transistor;
(d) a first conductive layer for forming a cell plate of said capacitor, formed in said trench and on said first insulating layer, said first conductive layer having substantially the same thickness as the first semiconductor layer of said pillar structure and sandwiching the first region of said second insulating layer with said first semiconductor layer;
(e) a third insulating layer formed on said first conductive layer;
(f) a second conductive layer formed on said third insulating layer and the second region of said second insulating layer, and said second conductive layer surrounding the pillar at a corresponding height of the second semiconductor layer and forming a gate electrode of said transistor, separated from adjacent second conductive layers in a first direction and connected with adjacent second conductive layers in a second direction different from the first direction, so as to form said word line; and
(g) a third conductive layer formed on said third semiconductor layer and connected with adjacent third semiconductor layers of said pillar structure along the first direction so as to form said bit line.

2. A semiconductor memory device having a memory cell according to claim 1, wherein said second semiconductor layer of the second conductivity type comprises two layers, a lower second semiconductor layer having a low impurity concentration and an upper second semiconductor layer having a high impurity concentration.

3. A semiconductor memory device having a memory cell according to claim 2, wherein the impurity concentration of the lower second semiconductor layer is about a tenth of that of the upper second semiconductor layer.

4. A semiconductor memory device having a memory cell according to claim 2 or 3, wherein a surface level of said first conductive layer is within a height range of the lower second semiconductor layer of said second semiconductor layer.

5. A semiconductor memory device having a memory cell comprising a transistor stacked on a capacitor thereof, a word line and a bit line, said semiconductor memory device comprising:
(a) a first insulating layer formed on a semiconductor substrate;
(b) a semiconductor pillar structure formed on said first insulating layer, said pillars being arranged on positions forming a matrix array and being isolated by trenches extending to said first insulating layer, said pillar structure comprising a first semiconductor layer of a second conductivity type, of an impurity concentration being so low that an inversion layer is formed on the inside surface of the dielectric film, formed on said first insulating layer, a second semiconductor layer of the second conductivity type of a high impurity concentration formed on said first semiconductor layer, and a third semiconductor layer of a first conductivity type opposite to the second conductivity type formed on said second semiconductor layer, and said transistor being formed in an upper portion of the pillar structure and said capacitor being formed in a lower portion of the pillar structure;
(c) a second insulating layer formed over a side surface of said pillar structure having a first and second regions, the first region being used as an insulating layer of said capacitor and the second region being used as a gate insulating layer of said transistor;
(d) a first conductive layer for forming a cell plate of said capacitor, formed in said trench and on said first insulating layer, said first conductive layer having substantially the same thickness as the first semiconductor layer of said pillar structure and sandwiching the first region of said second insulating layer with said first semiconductor layer;
(e) a third insulating layer formed on said first conductive layer;
(f) a second conductive layer formed on said third insulating layer and the second region of said second insulating layer, and said second conductive layer surrounding said pillar at a corresponding height of the second semiconductor layer and forming a gate electrode of said transistor, separated from adjacent second conductive layers in a first direction and connected with adjacent second conductive layers in a second direction different from the first direction, so as to form said word line; and
(g) a third conductive layer formed on said third semiconductor layer and connected with adjacent third semiconductor layers of said pillar structure along the first direction so as to form said bit line.

6. A semiconductor memory device having a memory cell according to claim 5, wherein said semiconductor substrate is of the second conductivity type and a hole is formed in said first insulating layer under said pillar structure and said first semiconductor layer contacts with the substrate through said hole.

7. A semiconductor memory device having a memory cell according to any of the preceding claims, wherein said semiconductor pillar structure is arranged in the matrix array having a gap between the pillars in the first direction greater than that in the second direction.

8. A semiconductor memory device having a memory cell according to any of the preceding claims, wherein said second conductive layer is of doped polysilicon and has a curved surface having a gradually decreasing thickness with height in cross section.

9. A method of manufacturing a semiconductor memory device having a memory cell comprising a transistor stacked on a capacitor thereof, a word line and a bit line, said method comprising the steps of:
(a) providing a substrate comprising a semiconductor base substrate, a first insulating layer formed thereon, a plurality of semiconductor layers on said first insulating layer, said plurality of layers comprising a first semiconductor layer of a first conductivity type or of a second conductivity type, a second semiconductor layer of a second conductivity type, and a third semiconductor layer of the first conductivity type opposite to the second conductivity type, said layers having an impurity concentration and a thickness which are necessary for forming a storage electrode of said capacitor and vertically arranged active regions of said transistor on the storage electrode;
(b) forming a semiconductor pillar structure arranged in a matrix array by selectively removing said plurality of semiconductor layers and forming a trench extending to said first insulating layer;
(c) forming a second insulating layer on a side surface of the semiconductor pillar;
(d) filling the trench between the pillars with a first conductive layer, a height of the first conductive layer being controlled to be substantially equal to that of said storage electrode, thereby a cell plate of the capacitor being formed;
(e) exposing the semiconductor pillar surface protruding above said first conductive layer and forming a gate insulating film on the exposed side surface of the semiconductor pillar and forming a third insulating layer on the cell plate;
(f) forming a gate electrode surrounding said semiconductor pillar with a second conductive layer, sandwiching said gate insulating film therebetween, and said gate electrode being insulated from the cell plate by said third insulating layer and separated from adjacent gate electrodes arranged in a first direction of the rectangular coordinates and connected with adjacent gate electrodes arranged in a second direction of the rectangular coordinates, and forming said word line;
(g) filling and leveling the remaining space in the trench with an insulating material, and exposing a top surface of the pillar; and
(h) forming a conductive line connecting a plurality of the exposed top surfaces of the pillars arranged in the first direction of the rectangular coordinates, and said conductive line forming said bit line.

10. A method of manufacturing a semiconductor memory device having a memory cell according to claim 9, wherein said step (a) of providing a substrate further comprises the following substeps of:
bringing two semiconductor substrates together, a silicon oxide layer being formed at least on one of substrates, and applying an electrical attracting force between said two substrates in a heated atmosphere, thereby said one of the substrates and the silicon dioxide layer respectively being used as said base substrate and said silicon dioxide layer in the step (a).

11. A method of manufacturing a semiconductor memory device having a memory cell according to claim 9 or 10, wherein said step (b) of forming a semiconductor pillar comprises a condition that the gap between adjacent semiconductor pillars in the first direction of the rectangular coordinates is greater than that in the second direction.

12. A method of manufacturing a semiconductor memory device having a memory cell according to any of claims 9, 10, or 11, wherein the material of the second insulating layer in said step (c) is one of materials selected from a group of silicon oxide, silicon nitride, and phosphosilicate glass.

13. A method of manufacturing a semiconductor memory device having a memory cell according to any of claims 9 to 12, wherein the material of the first conductive layer filling the trench in said step (d) is doped polysilicon.

14. A method of manufacturing a semiconductor memory device having a memory cell according to any of claims 9 to 13, wherein the material of the gate electrode formed in said step (f) is doped polysilicon.

15. A method of manufacturing a semiconductor memory device having a memory cell according to any of claims 9 to 14, wherein the material of the conductive line formed in said step (h) is aluminum or aluminum alloy.

## Patentansprüche

1. Halbleiterspeicheranordnung mit einer Speicherzelle, die einen Transistor, der auf einem Kondensator hiervon gestapelt ist, eine Wortleitung und eine Bitleitung aufweist, welche Halbleiterspeicheranordnung umfaßt:
(a) eine erste Isolierschicht, die auf einem Halbleitersubstrat gebildet ist;
(b) eine Halbleiterpfeilerstruktur, die auf der genannten ersten Isolierschicht gebildet ist, wobei die genannten Pfeiler an Positionen angeordnet sind, die ein Matrix-Array bilden, und durch Gräben getrennt sind, die sich zur genannten ersten Isolierschicht erstrecken, welche Pfeilerstruktur eine erste Halbleiterschicht von einem ersten Leitfähigkeitstyp, die auf der genannten ersten Isolierschicht gebildet ist, eine zweite Halbleiterschicht von einem zum ersten Leitfähigkeitstyp entgegengesetzten zweiten Leitfähigkeitstyp, die auf der genannten ersten Halbleiterschicht gebildet ist, und eine dritte Halbleiterschicht vom ersten Leitfähigkeitstyp, die auf der genannten zweiten Halbleiterschicht gebildet ist, umfaßt, und wobei der genannte Transistor in einem oberen Teil der Pfeilerstruktur gebildet ist und der genannte Kondensator in einem unteren Teil der Pfeilerstruktur gebildet ist;
(c) eine zweite Isolierschicht, die über einer Seitenfläche der genannten Pfeilerstruktur gebildet ist, mit einer ersten und einer zweiten Zone, wobei die erste Zone als Isolierschicht des genannten Kondensators verwendet wird und die zweite Zone als Gate-Isolierschicht des genannten Transistors verwendet wird;
(d) eine erste leitfähige Schicht zur Bildung einer Zellenplatte des genannten Kondensators, die im genannten Graben und auf der genannten ersten Isolierschicht gebildet ist, welche erste leitfähige Schicht im wesentlichen die gleiche Dicke wie die erste Halbleiterschicht der genannten Pfeilerstruktur aufweist und die erste Zone der genannten zweiten Isolierschicht mit der genannten ersten Halbleiterschicht sandwichartig anordnet;
(e) eine dritte Isolierschicht, die auf der genannten ersten leitfähigen Schicht gebildet ist;
(f) eine zweite leitfähige Schicht, die auf der genannten dritten Isolierschicht und der zweiten Zone der genannten zweiten Isolierschicht gebildet ist, und welche zweite leitfähige Schicht den Pfeiler in einer entsprechenden Höhe der zweiten Halbleiterschicht umgibt und eine Gate-Elektrode des genannten Transistors bildet, die von benachbarten zweiten leitfähigen Schichten in einer ersten Richtung getrennt ist und mit benachbarten zweiten leitfähigen Schichten in einer zweiten Richtung, die von der ersten Richtung verschieden ist, verbunden ist, um so die genannte Wortleitung zu bilden; und
(g) eine dritte leitfähige Schicht, die auf der genannten dritten Halbleiterschicht gebildet ist und mit benachbarten dritten Halbleiterschichten der genannten Pfeilerstruktur entlang der ersten Richtung verbunden ist, um so die genannte Bitleitung zu bilden.

2. Halbleiterspeicheranordnung mit einer Speicherzelle nach Anspruch 1, bei welcher die genannte zweite Halbleiterschicht vom zweiten Leitfähigkeitstyp zwei Schichten, eine untere zweite Halbleiterschicht mit einer niedrigen Verunreinigungskonzentration und eine obere zweite Halbleiterschicht mit einer hohen Verunreinigungskonzentration, umfaßt.

3. Halbleiterspeicheranordnung mit einer Speicherzelle nach Anspruch 2, bei welcher die Verunreinigungskonzentration der unteren zweiten Halbleiterschicht etwa ein Zehntel jener der oberen zweiten Halbleiterschicht beträgt.

4. Halbleiterspeicheranordnung mit einer Speicherzelle nach Anspruch 2 oder 3, bei welcher ein Oberflächenniveau der genannten ersten leitfähigen Schicht in einem Höhenbereich der unteren zweiten Halbleiterschicht der genannten zweiten Halbleiterschicht liegt.

5. Halbleiterspeicheranordnung mit einer Speicherzelle, die einen Transistor, der auf einem Kondensator hiervon gestapelt ist, eine Wortleitung und eine Bitleitung aufweist, welche Halbleiterspeicheranordnung umfaßt:
(a) eine erste Isolierschicht, die auf einem Halbleitersubstrat gebildet ist;
(b) eine Halbleiterpfeilerstruktur, die auf der genannten ersten Isolierschicht gebildet ist, wobei die genannten Pfeiler an Positionen angeordnet sind, die ein Matrix-Array bilden, und durch Gräben isoliert sind, die sich zur genannten ersten Isolierschicht erstrecken, welche Pfeilerstruktur eine erste Halbleiterschicht, die auf der genannten ersten Isolierschicht gebildet ist, von einem zweiten Leitfähigkeitstyp mit einer Verunreinigungskonzentration, die so niedrig ist, daß eine Inversionsschicht an der Innenfläche des dielektrischen Films gebildet wird, eine zweite Halbleiterschicht, die auf der genannten ersten Halbleiterschicht gebildet ist, vom zweiten Leitfähigkeitstyp mit einer hohen Verunreinigungskonzentration und eine dritte Halbleiterschicht, die auf der zweiten Halbleiterschicht gebildet ist, von einem zum zweiten Leitfähigkeitstyp entgegengesetzten ersten Leitfähigkeitstyp umfaßt, und wobei der genannte Transistor in einem oberen Teil der Pfeilerstruktur gebildet ist und der genannte Kondensator in einem unteren Teil der Pfeilerstruktur gebildet ist;
(c) eine zweite Isolierschicht, die über einer Seitenfläche der genannten Pfeilerstruktur gebildet ist, mit einer ersten und einer zweiten Zone, wobei die erste Zone als Isolierschicht des genannten Kondensators verwendet wird und die zweite Zone als Gate-Isolierschicht des genannten Transistors verwendet wird;
(d) eine erste leitfähige Schicht zur Bildung einer Zellenplatte des genannten Kondensators, die im genannten Graben und auf der genannten ersten Isolierschicht gebildet ist, welche erste leitfähige Schicht im wesentlichen die gleiche Dicke wie die erste Halbleiterschicht der genannten Pfeilerstruktur aufweist und die erste Zone der genannten zweiten Isolierschicht mit der genannten ersten Halbleiterschicht sandwichartig anordnet;
(e) eine dritte Isolierschicht, die auf der genannten ersten leitfähigen Schicht gebildet ist;
(f) eine zweite leitfähige Schicht, die auf der genannten dritten Isolierschicht und der zweiten Zone der genannten zweiten Isolierschicht gebildet ist, und welche zweite leitfähige Schicht den Pfeiler in einer entsprechenden Höhe der zweiten Halbleiterschicht umgibt und eine Gate-Elektrode des genannten Transistors bildet, die von benachbarten zweiten leitfähigen Schichten in einer ersten Richtung getrennt ist und mit benachbarten zweiten leitfähigen Schichten in einer zweiten Richtung, die von der ersten Richtung verschieden ist, verbunden ist, um so die genannte Wortleitung zu bilden; und
(g) eine dritte leitfähige Schicht, die auf der genannten dritten Halbleiterschicht gebildet ist und mit benachbarten dritten Halbleiterschichten der genannten Pfeilerstruktur entlang der ersten Richtung verbunden ist, um so die genannte Bitleitung zu bilden.

6. Halbleiterspeicheranordnung mit einer Speicherzelle nach Anspruch 5, bei welcher das Halbleitersubstrat vom zweiten Leitfähigkeitstyp ist und ein Loch in der genannten ersten Isolierschicht unter der genannten Pfeilerstruktur gebildet ist und die genannte erste Halbleiterschicht mit dem Substrat durch das genannte Loch in Kontakt kommt.

7. Halbleiterspeicheranordnung mit einer Speicherzelle nach einem der vorhergehenden Ansprüche, bei welcher die genannte Halbleiterpfeilerstruktur im Matrix-Array angeordnet ist, das einen Spalt zwischen den Pfeilern in der ersten Richtung aufweist, der größer ist als jener in der zweiten Richtung.

8. Halbleiterspeicheranordnung mit einer Speicherzelle nach einem der vorhergehenden Ansprüche, bei welcher die genannte zweite leitfähige Schicht aus dotiertem Polysilizium besteht und eine gekrümmte Fläche aufweist, deren Dicke mit der Höhe im Querschnitt allmählich abnimmt.

9. Verfahren zur Herstellung einer Halbleiteranordnung mit einer Speicherzelle, die einen Transistor, der auf einem Kondensator hiervon gestapelt ist, eine Wortleitung und eine Bitleitung aufweist, welches Verfahren die Schritte umfaßt:
(a) Vorsehen eines Substrats, das ein Halbleiter-Basissubstrat, eine darauf gebildete erste Isolierschicht, eine Vielzahl von Halbleiterschichten auf der genannten ersten Isolierschicht umfaßt, wobei die genannte Vielzahl von Schichten eine erste Halbleiterschicht von einem ersten Leitfähigkeitstyp oder von einem zweiten Leitfähigkeitstyp, eine zweite Halbleiterschicht von einem zweiten Leitfähigkeitstyp und eine dritte Halbleiterschicht von einem zum zweiten Leitfähigkeitstyp entgegengesetzten ersten Leitfähigkeitstyp umfaßt, welche Schichten eine Verunreinigungskonzentration und eine Dicke aufweisen, die zur Bildung einer Speicherelektrode des genannten Kondensators und vertikal angeordneter aktiver Zonen des genannten Transistors an der Speicherelektrode notwendig sind;
(b) Bilden einer Halbleiterpfeilerstruktur, die in einem Matrix-Array angeordnet ist, durch selektives Entfernen der genannten Vielzahl von Halbleiterschichten und Bilden eines Grabens, der sich zur genannten ersten Isolierschicht erstreckt;
(c) Bilden einer zweiten Isolierschicht an einer Seitenfläche des Halbleiterpfeilers;
(d) Füllen des Grabens zwischen den Pfeilern mit einer ersten leitfähigen Schicht, wobei eine Höhe der ersten leitfähigen Schicht eingerichtet wird, um im wesentlichen gleich jener der genannten Speicherelektrode zu sein, wodurch eine Zellenplatte des Kondensators gebildet wird;
(e) Freilegen der Halbleiterpfeilerfläche, die oberhalb der genannten ersten leitfähigen Schicht vorsteht, und Bilden eines Gate-Isolierfilms an der freigelegten Seitenfläche des Halbleiterpfeilers und Bilden einer dritten Isolierschicht auf der Zellenplatte;
(f) Bilden einer Gate-Elektrode, die den genannten Halbleiterpfeiler umgibt, mit einer zweiten leitfähigen Schicht, wobei der genannten Gate-Isolierfilm sandwichartig dazwischen angeordnet wird, und welche Gate-Elektrode gegen die Zellenplatte durch die genannte dritte Isolierschicht isoliert ist und von benachbarten Gate-Elektroden, die in einer ersten Richtung der rechtwinkeligen Koordinaten angeordnet sind, getrennt ist und mit benachbarten Gate-Elektroden, die in einer zweiten Richtung der rechtwinkeligen Koordinaten angeordnet sind, verbunden ist, und Bilden der genannten Wortleitung;
(g) Füllen und Planieren des verbleibenden Raums im Graben mit einem Isoliermaterial und Freilegen einer Oberseitenfläche des Pfeilers; und
(h) Bilden einer leitfähigen Leitung, die eine Vielzahl der freigelegten Oberseitenflächen der Pfeiler, die in der ersten Richtung der rechtwinkeligen Koordinaten angeordnet sind, verbindet, und welche leitfähige Leitung die genannte Bitleitung bildet.

10. Verfahren zur Herstellung einer Halbleiterspeicheranordnung mit einer Speicherzelle nach Anspruch 9, bei welchem der genannte Schritt (a) des Vorsehens eines Substrats ferner die folgenden Teilschritte umfaßt:
Zusammenbringen von zwei Halbleitersubstraten, wobei eine Siliziumoxidschicht zumindest auf einem der Substrate gebildet wird, und Ausüben einer elektrischen Anziehungskraft zwischen den zwei Substraten in einer erhitzten Atmosphäre, wodurch das genannte eine der Substrate und die Siliziumdioxidschicht als genanntes Basissubstrat bzw. genannte Siliziumdioxidschicht in Schritt (a) verwendet werden.

11. Verfahren zur Herstellung einer Halbleiterspeicheranordnung mit einer Speicherzelle nach Anspruch 9 oder 10, bei welchem der genannte Schritt (b) der Bildung eines Halbleiterpfeilers eine Bedingung umfaßt, daß der Spalt zwischen benachbarten Halbleiterpfeilern in der ersten Richtung der rechtwinkeligen Koordinaten größer ist als jener in der zweiten Richtung.

12. Verfahren zur Herstellung einer Halbleiterspeicheranordnung mit einer Speicherzelle nach Anspruch 9, 10 oder 11, bei welchem das Material der zweiten Isolierschicht im genannten Schritt (c) eines von Materialien ist, die aus einer Gruppe von Siliziumoxid, Siliziumnitrid und Phosphorsilikaglas ausgewählt sind.

13. Verfahren zur Herstellung einer Halbleiterspeicheranordnung mit einer Speicherzelle nach einem der Ansprüche 9 bis 12, bei welchem das Material der ersten leitfähigen Schicht, das den Graben im genannten Schritt (d) füllt, dotiertes Polysilizium ist.

14. Verfahren zur Herstellung einer Halbleiterspeicheranordnung mit einer Speicherzelle nach einem der Ansprüche 9 bis 13, bei welchem das Material der Gate-Elektrode, die im genannten Schritt (f) gebildet wird, dotiertes Polysilizium ist.

15. Verfahren zur Herstellung einer Halbleiterspeicheranordnung mit einer Speicherzelle nach einem der Ansprüche 9 bis 14, bei welchem das Material der leitfähigen Leitung, die im genannten Schritt (h) gebildet wird, Aluminium oder eine Aluminiumlegierung ist.

## Revendications

1. Dispositif de mémoire à semiconducteur comportant une cellule de mémoire comprenant un transistor empilé sur une capacité de celle-ci, une ligne de mot et une ligne de bit, ledit dispositif de mémoire à semiconducteur comprenant :
(a) une première couche d'isolation formée sur un substrat semiconducteur ;
(b) une structure de piliers semiconductrice formée sur ladite première couche d'isolation, lesdits piliers étant agencés en des positions formant un réseau matriciel et étant séparés par des tranchées s'étendant jusqu'à ladite première couche d'isolation, ladite structure de piliers comprenant une première couche semiconductrice d'un premier type de conductivité formée sur ladite première couche d'isolation, une seconde couche semiconductrice d'un second type de conductivité opposé au premier type de conductivité formée sur ladite première couche semiconductrice et une troisième couche semiconductrice du premier type de conductivité formée sur ladite seconde couche semiconductrice et ledit transistor étant formé dans une partie supérieure de la structure de piliers et ladite capacité étant formée dans une partie inférieure de la structure de piliers ;
(c) une seconde couche d'isolation formée sur une surface latérale de ladite structure de piliers comportant des première et seconde régions, la première région étant utilisée en tant que couche d'isolation de ladite capacité et la seconde région étant utilisée en tant que couche d'isolation de grille dudit transistor ;
(d) une première couche conductrice pour former une plaque de cellule de ladite capacité, formée dans ladite tranchée et sur ladite première couche d'isolation, ladite première couche conductrice présentant sensiblement la même épaisseur que la première couche semiconductrice de ladite structure de piliers et prenant en sandwich la première région de ladite seconde couche d'isolation avec ladite première couche semiconductrice ;
(e) une troisième couche d'isolation formée sur ladite première couche conductrice ;
(f) une seconde couche conductrice formée sur ladite troisième couche d'isolation et sur la seconde région de ladite seconde couche d'isolation et ladite seconde couche conductrice entourant le pilier selon une hauteur correspondante de la seconde couche semiconductrice et formant une électrode de grille dudit transistor, séparée de secondes couches conductrices adjacentes selon une première direction et connectée à des secondes couches conductrices adjacentes selon une seconde direction différente de la première direction de manière à former ladite ligne de mot ; et
(g) une troisième couche conductrice formée sur ladite troisième couche semiconductrice et connectée a des troisièmes couches semiconductrices adjacentes de ladite structure de piliers selon la première direction de manière à former ladite ligne de bit.

2. Dispositif de mémoire à semiconducteur comportant une cellule de mémoire selon la revendication 1, dans lequel ladite seconde couche semiconductrice du second type de conductivité comprend deux couches, une seconde couche semiconductrice inférieure présentant une concentration en impureté faible et une seconde couche semiconductrice supérieure présentant une concentration en impureté élevée.

3. Dispositif de mémoire à semiconducteur comportant une cellule de mémoire selon la revendication 2, dans lequel la concentration en impureté de la seconde couche semiconductrice inférieure vaut environ un dixième de celle de la seconde couche semiconductrice supérieure.

4. Dispositif de mémoire à semiconducteur comportant une cellule de mémoire selon la revendication 2 ou 3, dans lequel un niveau de surface de ladite première couche conductrice se situe dans une plage de hauteurs de la seconde couche semiconductrice inférieure de ladite seconde couche semiconductrice.

5. Dispositif de mémoire à semiconducteur comportant une cellule de mémoire comprenant un transistor empilé sur une capacité de celle-ci, une ligne de mot et une ligne de bit, ledit dispositif de mémoire à semiconducteur comprenant :
(a) une première couche d'isolation formée sur un substrat semiconducteur ;
(b) une structure de piliers semiconductrice formée sur ladite première couche d'isolation, lesdits piliers étant agencés en des positions formant un réseau matriciel et étant isolés par des tranchées s'étendant jusqu'à ladite première couche d'isolation, ladite structure de piliers comprenant une première couche semiconductrice d'un second type de conductivité présentant une concentration en impureté qui est si faible qu'une couche d'inversion est formée sur la surface interne du film diélectrique formé sur ladite première couche d'isolation, une seconde couche semiconductrice du second type de conductivité présentant une concentration en impureté élevée formée sur ladite première couche semiconductrice et une troisième couche semiconductrice d'un premier type de conductivité opposé au second type de conductivité formée sur ladite seconde couche semiconductrice et ledit transistor étant formé dans une partie supérieure de la structure de piliers et ladite capacité étant formée dans une partie inférieure de la structure de piliers ;
(c) une seconde couche d'isolation formée sur une surface latérale de ladite structure de piliers comportant des première et seconde régions, la première région étant utilisée en tant que couche d'isolation de ladite capacité et la seconde région étant utilisée en tant que couche d'isolation de grille dudit transistor ;
(d) une première couche conductrice pour former une plaque de cellule de ladite capacité, formée dans ladite tranchée et sur ladite première couche d'isolation, ladite première couche conductrice présentant sensiblement la même épaisseur que la première couche semiconductrice de ladite structure de piliers et prenant en sandwich la première région de ladite seconde couche d'isolation avec ladite première couche semiconductrice ;
(e) une troisième couche d'isolation formée sur ladite première couche conductrice ;
(f) une seconde couche conductrice formée sur ladite troisième couche d'isolation et sur la seconde région de ladite seconde couche d'isolation et ladite seconde couche conductrice entourant ledit pilier selon une hauteur correspondante de la seconde couche semiconductrice et formant une électrode de grille dudit transistor, séparée de secondes couches conductrices adjacentes selon une première direction et connectée à des secondes couches conductrices adjacentes selon une seconde direction différente de la première direction de manière à former ladite ligne de mot ; et
(g) une troisième couche conductrice formée sur ladite troisième couche semiconductrice et connectée à des troisièmes couches semiconductrices adjacentes de ladite structure de piliers selon la première direction de manière à former ladite ligne de bit.

6. Dispositif de mémoire à semiconducteur comportant une cellule de mémoire selon la revendication 5, dans lequel ledit substrat semiconducteur est du second type de conductivité et un trou est formé dans ladite première couche d'isolation sous ladite structure de piliers et ladite première couche semiconductrice entre en contact avec le substrat au travers dudit trou.

7. Dispositif de mémoire à semiconducteur comportant une cellule de mémoire selon l'une quelconque des revendications précédentes, dans lequel ladite structure de piliers semiconductrice est agencée selon le réseau matriciel comportant un espace séparant les piliers selon la première direction qui est plus grand que celui selon la seconde direction.

8. Dispositif de mémoire à semiconducteur comportant une cellule de mémoire selon l'une quelconque des revendications précédentes, dans lequel ladite seconde couche conductrice est un polysilicium dopé et elle présente une surface incurvée dont l'épaisseur diminue progressivement en fonction de la hauteur en coupe transversale.

9. Procédé de fabrication d'un dispositif de mémoire à semiconducteur comportant une cellule de mémoire comprenant un transistor empilé sur une capacité de celle-ci, une ligne de mot et une ligne de bit, ledit procédé comprenant les étapes de :
(a) fourniture d'un substrat comprenant un substrat de base semiconducteur, une première couche d'isolation formée dessus, une pluralité de couches semiconductrices formées sur ladite première couche d'isolation, ladite pluralité de couches comprenant une première couche semiconductrice d'un premier type de conductivité ou d'un second type de conductivité, une seconde couche semiconductrice d'un second type de conductivité et une troisième couche semiconductrice du premier type de conductivité opposé au second type de conductivité, lesdites couches présentant une concentration en impureté et une épaisseur qui sont nécessaires pour former une électrode de stockage de ladite capacité et des régions actives agencées verticalement dudit transistor sur l'électrode de stockage ;
(b) formation d'une structure de piliers semiconductrice agencée selon un réseau matriciel en ôtant de façon sélective ladite pluralité de couches semiconductrices et en formant une tranchée s'étendant jusqu'à ladite première couche d'isolation ;
(c) formation d'une seconde couche d'isolation sur une surface latérale du pilier semiconducteur ;
(d) remplissage de la tranchée située entre les piliers au moyen d'une première couche conductrice, une hauteur de la première couche conductrice étant commandée de manière à être sensiblement égale à celle de ladite électrode de stockage d'où il résulte qu'une plaque de cellule de la capacité est formée ;
(e) mise à nu de la surface de pilier semiconducteur qui se projette au-dessus de ladite première couche semiconductrice et formation d'un film d'isolation de grille sur la surface latérale mise à nu du pilier semiconducteur et formation d'une troisième couche d'isolation sur la plaque de cellule ;
(f) formation d'une électrode de grille entourant ledit pilier semiconducteur avec une seconde couche conductrice, prise en sandwich dudit film d'isolation de grille entre, et ladite électrode de grille étant isolée de la plaque de cellule par ladite troisième couche d'isolation et étant séparée d'électrodes de grille adjacentes agencées selon une première direction des coordonnées rectangulaires et étant connectée à des électrodes de grille adjacentes agencées selon une seconde direction des coordonnées rectangulaires et formation de ladite ligne de mot ;
(g) remplissage et nivellement de l'espace restant dans la tranchée avec un matériau d'isolation et mise à nu d'une surface supérieure du pilier ; et
(h) formation d'une ligne conductrice connectant une pluralité des surfaces supérieures mises à nu des piliers agencés suivant la première direction des coordonnées rectangulaires et ladite ligne conductrice formant ladite ligne de bit.

10. Procédé de fabrication d'un dispositif de mémoire à semiconducteur comportant une cellule de mémoire selon la revendication 9, dans lequel ladite étape (a) de fourniture d'un substrat comprend en outre les sous-étapes suivantes de :
mise ensemble de deux substrats semiconducteurs, une couche d'oxyde de silicium étant formée sur au moins l'un des substrats, et application d'une force d'attraction électrique entre lesdits deux substrats dans une atmosphère chauffée, dans lequel ledit substrat considéré et que la couche de dioxyde de silicium sont respectivement utilisés en tant que dit substrat de base et que dite couche de dioxyde de silicium de l'étape (a).

11. Procédé de fabrication d'un dispositif de mémoire à semiconducteur comportant une cellule de mémoire selon la revendication 9 ou 10, dans lequel ladite étape (b) de formation d'un pilier semiconducteur comprend une condition qui consiste en ce que l'espace séparant des piliers semiconducteurs adjacents selon la première direction des coordonnées rectangulaires est supérieur à celui selon la seconde direction.

12. Procédé de fabrication d'un dispositif de mémoire à semiconducteur comportant une cellule de mémoire selon l'une quelconque des revendications 9, 10 ou 11, dans lequel le matériau de la seconde couche d'isolation de ladite étape (C) est un matériau choisi parmi le groupe qui comprend l'oxyde de silicium, le nitrure de silicium et le verre de phosphosilicate.

13. Procédé de fabrication d'un dispositif de mémoire à semiconducteur comportant une cellule de mémoire selon l'une quelconque des revendications 9 à 12, dans lequel le matériau de la première couche conductrice remplissant la tranchée au niveau de ladite étape (d) est du polysilicium dopé.

14. Procédé de fabrication d'un dispositif de mémoire à semiconducteur comportant une cellule de mémoire selon l'une quelconque des revendications 9 à 13, dans lequel le matériau de la ligne conductrice formée au niveau de ladite étape (f) est du polysilicium dopé.

15. Procédé de fabrication d'un dispositif de mémoire à semiconducteur comportant une cellule de mémoire selon l'une quelconque des revendications 9 à 14, dans lequel le matériau de la ligne conductrice formée au niveau de ladite étape (h) est de l'aluminium ou un alliage d'aluminium.
